Europäisches Patentamt

European Patent Office

Office européen des brevets

(19)

(11) Veröffentlichungsnummer : **0 542 710 A1**

## (12) EUROPÄISCHE PATENTANMELDUNG

(21) Anmeldenummer : **92890238.6**

(22) Anmeldetag : **06.11.92**

(51) Int. Cl.$^5$ : **H03F 1/32, H04R 25/00**

(30) Priorität : **13.11.91 AT 2245/91**

(43) Veröffentlichungstag der Anmeldung :
**19.05.93 Patentblatt 93/20**

(84) Benannte Vertragsstaaten :
**CH DE DK GB LI**

(71) Anmelder : **VIENNATONE Gesellschaft m.b.H.**
**Fröbelgasse 28-32**
**A-1164 Wien (AT)**

(72) Erfinder : **Ribic, Zlatan, Dr.**
**Anton-Baumgartner-Strasse 44/A8/52**
**A-1230 Wien (AT)**

(74) Vertreter : **Kliment, Peter, Dipl.-Ing. Mag.-jur.**
**Singerstrasse 8/3/8**
**A-1010 Wien (AT)**

(54) **Verfahren zur Bearbeitung von Signalen.**

(57)   Verfahren und Vorrichtung zur Bearbeitung von Signalen, insbesonders von Audio-Signalen für Hörgeräte. Eine verzögerungsfreie Signalbearbeitung wird dadurch erreicht, daß zunächst ein momentanes Amplitudensignal $A(t)$ hergestellt wird, dessen Stärke proportional der momentanen Amplitude des Eingangssignales $u_i(t)$ ist und daß dieses momentane Amplitudensignal $A(t)$ zur Bearbeitung des Eingangssignales $u_i(t)$ herangezogen wird.

Fig. 1

Die Erfindung betrifft ein Verfahren zur Bearbeitung von Signalen, insbesonders von Audio-Signalen für Hörgeräte.

Es ist ein stets bei der Übertragung und Verstärkung von Tonsignalen auftretendes Problem, die Dynamik an die entsprechenden Erfordernisse anzupassen. Auch bei der Übertragung von anderen Signalen, z.B. von Datensignalen über Modems stellt sich diese Aufgabe.

Bei Hörgeräten besteht ein besonderes Problem darin, daß leise Geräusche besonders stark verstärkt werden müssen, um vom Träger wahrgenommen werden zu können. Dann werden jedoch laute Geräusche in manchen Fällen zu stark verstärkt, was sehr unangenehm sein kann.

Es sind nun eine Reihe von Verfahren bekannt, die eine Kompression der Signale bewirken. Diese Verfahren haben den Nachteil, daß sie zumeist eine gewisse Einschwingzeit benötigen, sodaß eine Verzögerung im Ansprechverhalten gegeben ist. Eine solche Verzögerung ist im allgemeinen unerwünscht, da auf diese Weise etwa leise Töne, die unmittelbar nach lauteren Tönen auftreten, verdeckt werden.

Ein weiterer Nachteil besteht darin, daß solche Schaltungen zur Dynamikkompression oft nicht oder nur unzureichend einstellbar und regelbar sind.

Aufgabe der Erfindung ist es, diese Nachteile zu vermeiden und ein Verfahren zu schaffen, mit dem eine reaktionszeitfreie Signalbearbeitung möglich ist.

Erfindungsgemäß ist daher vorgesehen, daß zunächst ein momentanes Amplitudensignal A(t) hergestellt wird, das der Amplitude des Eingangssignales $u_i(t)$ entspricht und daß dieses momentane Amplitudensignal A(t) zur Bearbeitung des Eingangssignales $u_i(t)$ herangezogen wird. Da dieses momentane Amplitudensignal A(t) in Echtzeit vorliegt, kann eine verzögerungsfreie Signalbearbeitung vorgenommen werden. Je nach Bedarf kann eine Kompression oder Expansion der Dynamik erreicht werden.

Eine Kompression der Dynamik wird erreicht, wenn das Eingangssignal $u_i(t)$ durch das gegebenenfalls um eine Konstante K vermehrte momentane Amplitudensignal A(t) dividiert wird. Die Konstante K verhindert eine unerlaubte Division durch Null. Wenn die Konstante K hinreichend klein gewählt wird, so besitzt das Ausgangssignal eine praktisch konstante Amplitude, also einen verschwindenden Dynamikumfang. Dies kann im Fall von Datenübertragungssystemen, die Telefonleitungen benutzen, erwünscht sein.

Eine besonders einfache und weitgehende Regelbarkeit der Signalbearbeitung kann dadurch erreicht werden, daß das momentane Amplitudensignal A(t) zur Steuerung der Verstärkung des Eingangssignales $u_i(t)$ herangezogen wird.

In einer besonders vorteilhaften Variante des erfindungsgemäßen Verfahrens sind folgende Schritte vorgesehen:
- Erzeugung eines analytischen Signales, bestehend aus zwei Hilbert-Signalen $h_1(t)$, $h_2(t)$, dessen Energiespektrum dem des Eingangssignales $u_i(t)$ entspricht;
- Bildung der Quadratwurzel aus der Summe der Quadrate der beiden Hilbert-Signale $h_1(t)$ und $h_2(t)$.

Als analytisches Signal wird ein komplexes Signal bezeichnet, dessen imaginäre Komponente die Hilbert-Transformierte der realen Komponente darstellt. Die mathematischen Grundlagen sind bekannt und etwa in R. B. Randall: "Frequency Analysis", Brüel & Kjaer, 1987 ausführlich beschrieben. Wegen dieser Eigenschaft werden in der Folge die beiden Komponenten des analytischen Signals kurz als Hilbert-Signale bezeichnet.

Die Hilbert-Transformation erzeugt aus einer Funktion eine andere Funktion, deren Amplitudenspektrum identisch ist, deren Phasenlage in allen Frequenzen jedoch um $\pi/2$ verschoben ist. Es wäre nun im Prinzip möglich, das Eingangsignal einer solchen Hilbert-Transformation zu unterwerfen. Dies ist jedoch schaltungstechnisch sehr schwierig zu realisieren. Es ist jedoch ohne weiteres möglich, zwei Ausgangssignale zu erzeugen, die beide im Amplitudenspektrum mit dem Eingangssignal übereinstimmen und deren Phasenlage untereinander um $\pi/2$ verschoben ist. Das momentane Amplitudensignal A(t) wird dadurch gewonnen, daß die Quadratwurzel aus der Summe der Quadrate der beiden Hilbert-Signale $h_1(t)$ und $h_2(t)$ gebildet wird.

Weiters betrifft die Erfindung eine Vorrichtung zur Bearbeitung von Signalen, insbesonders von Audio-Signalen für Hörgeräte. Diese ist erfindungsgemäß so ausgebildet, daß eine Amplitudensignalschaltung vorgesehen ist, mit der ein momentanes Amplitudensignal A(t) herstellbar ist, dessen momentane Stärke im wesentlichen proportional der momentanen Amplitude des Eingangssignales $u_i(t)$ ist und daß weiters ein Verknüpfungsglied vorgesehen ist, in dem dieses Amplitudensignal A(t) mit dem Eingangssignales $u_i(t)$ verknüpft wird.

Es ist vorteilhaft, wenn das Verknüpfungsglied eine Divisionsschaltung aufweist, in der das Eingangssignal $u_i(t)$ durch das momentane Amplitudensignal A(t) dividiert werden kann. Damit wird eine starke Reduktion des Dynamikumfanges erreicht.

Um eine unerlaubte Division durch Null zu verhindern kann ein Addierer sowie eine einstellbare Signalquelle vorgesehen sein, wobei an den Eingängen des Addierers der Ausgang der Amplitudensignalschaltung sowie der einstellbaren Signalquelle angeschlossen sind.

Bei einer bevorzugten Ausführungsvariante der Erfindung ist vorgesehen, daß an den Ausgang der Amplitudensignalschaltung ein nichtlineares Übertragungsglied angeschlossen ist, das einen spannungsgesteuerten Verstärker für das Eingangssignal $u_i(t)$ ansteuert. Je nach der Charakteristik des nichtlinearen Übertragungsgliedes kann dabei jegliche gewünschte Übertragungsfunktion realisiert werden. Der spannungsgesteuerte Verstärker stellt dabei zusammen mit dem nichtlinearen Übertragungsglied das Verknüpfungsglied dar.

Es kann auch vorgesehen sein, daß zum nichtlinearen Übertragungsglied ein Zeitglied in Serie geschaltet ist. Dieses Zeitglied, das ein Totzeitglied oder ein Verzögerungsglied sein kann, ermöglicht es auch die Steilheit von Signalanstiegen zu beeinflussen.

Vorzugsweise weist die Amplitudensignalschaltung folgende Bestandteile auf:

- eine Hilbert-Schaltung (HS) mit zwei Ausgängen, an denen zwei aus einem Eingangssignal $u_i(t)$ gewonnene Hilbert-Signale $h_1(t)$ und $h_2(t)$ anliegen, die die beiden Komponenten eines analytischen Signales darstellen;
- eine Verknüpfungsschaltung, die mit ihren beiden Eingängen an die Ausgänge der Hilbert-Schaltung angeschlossen ist und die bei an den Eingängen anliegenden Signalen $h_1(t)$ und $h_2(t)$ ein Ausgangssignal $A(t)$ nach folgendem Algorithmus erzeugt:

$$A(t) = \sqrt{h_1^2(t) + h_2^2(t)} .$$

Im folgenden wird die Erfindung anhand von den in den Figuren dargestellten Ausführungsbeispielen näher erläutert. Die Fig. zeigen schematisch:

Die Fig. 1 bis 3 Blockschaltbilder verschiedener Ausführungsvarianten der Erfindung,

die Fig. 4 ein Blockschaltbild der Hilbert-Schaltung;

die Fig. 5 eine schaltungstechnische Realisierung der Hilbert-Schaltung;

die Fig. 6 ein Blockschaltbild einer Variante der Hilbert-Schaltung;

die Fig. 7 eine schaltungstechnische Realisierung der Verknüpfungsschaltung;

die Fig. 8 und 9 Diagramme der Eingangs- und Ausgangssignale.

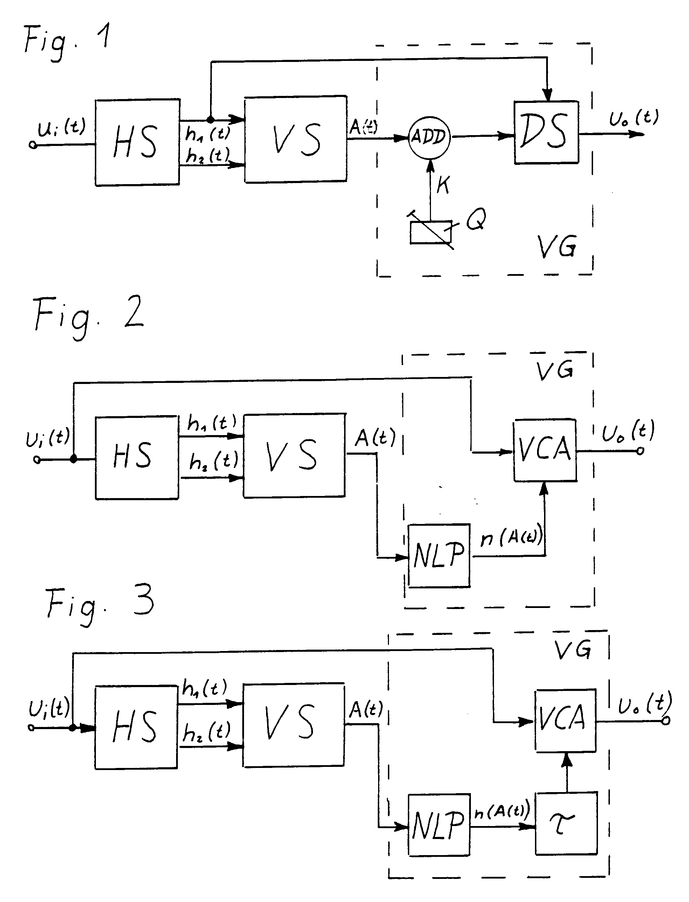

Bei der in der Fig. 1 dargestellten Ausführungsvariante der Erfindung werden mittels der Hilbert-Schaltung HS aus dem Eingangssignal $u_i(t)$ zwei Hilbert-Signale $h_1(t)$ und $h_2(t)$ gewonnen.

Eine Verknüpfungsschaltung VS ist mit ihren beiden Eingängen an die Ausgänge der Hilbert-Schaltung HS angeschlossen und erzeugt bei an den Eingängen anliegenden Signalen $h_1(t)$ und $h_2(t)$ ein Ausgangssignal $A(t)$ nach folgendem Algorithmus:

$$A(t) = \sqrt{h_1^2(t) + h_2^2(t)} .$$

Dieses momentane Amplitudensignal $A(t)$ wird im Verknüpfungsglied VS weiter verarbeitet. Es wird dabei in einem Addierer ADD um ein von einer einstellbaren Signalquelle Q erzeugtes konstantes Signal K vermehrt. In einer Divisionsschaltung DS wird folgende Operation durchgeführt:

$$u_o(t) = h_1(t) / (A(t) + K) .$$

Für das Endergebnis ist es unerheblich, ob als Divisor das Eingangssignal $u_i(t)$ oder, wie in Fig. 1 dargestellt, ein Hilbert-Signal $h_1(t)$ verwendet wird.

Eine solche Schaltung entspricht einem Compressor ohne Einschwing- und Ausschwingzeiten, der für einen isolierten Ton keine Verzerrungen verursacht. Bei gleichzeitigem Vorhandensein mehrerer Sinuskomponenten entstehen offensichtlich Intermodulationsverzerrungen. Dennoch klingt das Ausgangssignal weitgehend natürlich, da in der menschlichen Cochlea ähnliche Verzerrungen auftreten.

Bei der in der Fig. 2 dargestellten Ausführungsvariante wird das momentane Amplitudensignal $A(t)$ über ein nichtlineares Übertragungsglied NLP einem spannungsgesteuerten Verstärker VCA zugeleitet. Dieser Verstärker VCA verstärkt das Eingangssignal $u_i(t)$ in Abhängigkeit vom Signal $n(A(t))$, das am Ausgang des nichtlinearen Übertragungsgliedes NLP anliegt. Je nach der Charakteristik des nichtlinearen Übertragungsgliedes NLP kann jedes beliebige Dynamikverhalten eingestellt werden. Auch ist über dieses leicht eine Regelung, etwa in Abhängigkeit von der Frequenz oder eine manuelle Einstellbarkeit möglich.

In der Fig. 3 ist dem nichtlinearen Übertragungsglied NLP ein Verzögerungsglied $\tau$ nachgeschaltet. Damit ist auch die Realisierung von zeitselektiven Übertragungsfunktionen möglich.

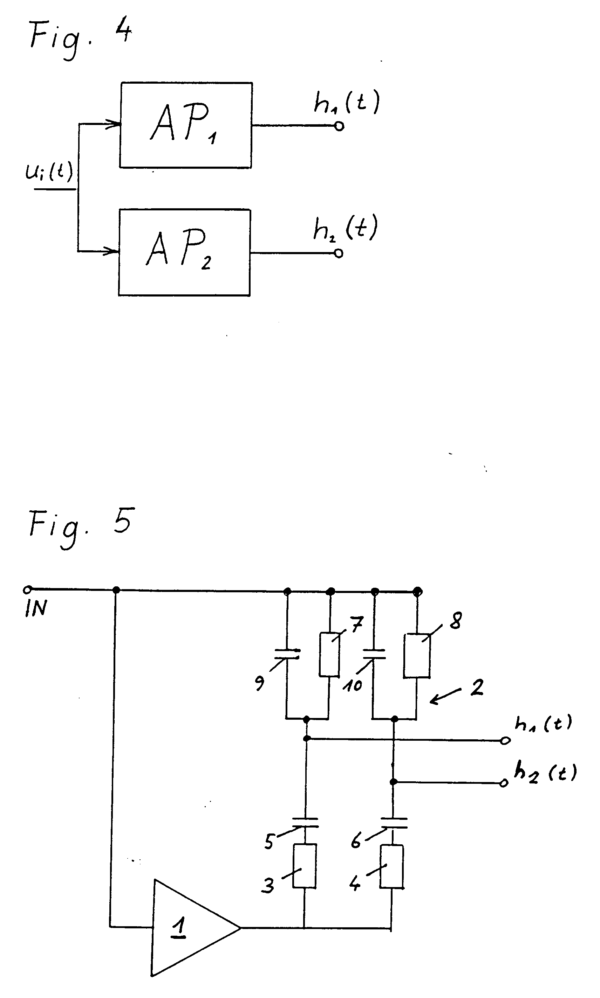

Aus der Fig. 4 geht hervor, daß die Hilbert-Schaltung HS aus mindestens zwei Allpässen $AP_1$, $AP_2$ aufgebaut sein kann. Das Übertragungsverhalten der Allpässe $AP_1$, $AP_2$ ist dabei so gewählt, daß im gewünschten Frequenzbereich an den zwei Ausgängen Hilbert-Signale $h_1(t)$ und $h_2(t)$ anliegen, von denen jeweils ein Signal $h_1(t)$ bzw. $h_2(t)$ im wesentlichen die Hilbert-Transformation des anderen Signales $h_2(t)$ bzw. $h_1(t)$ darstellt.

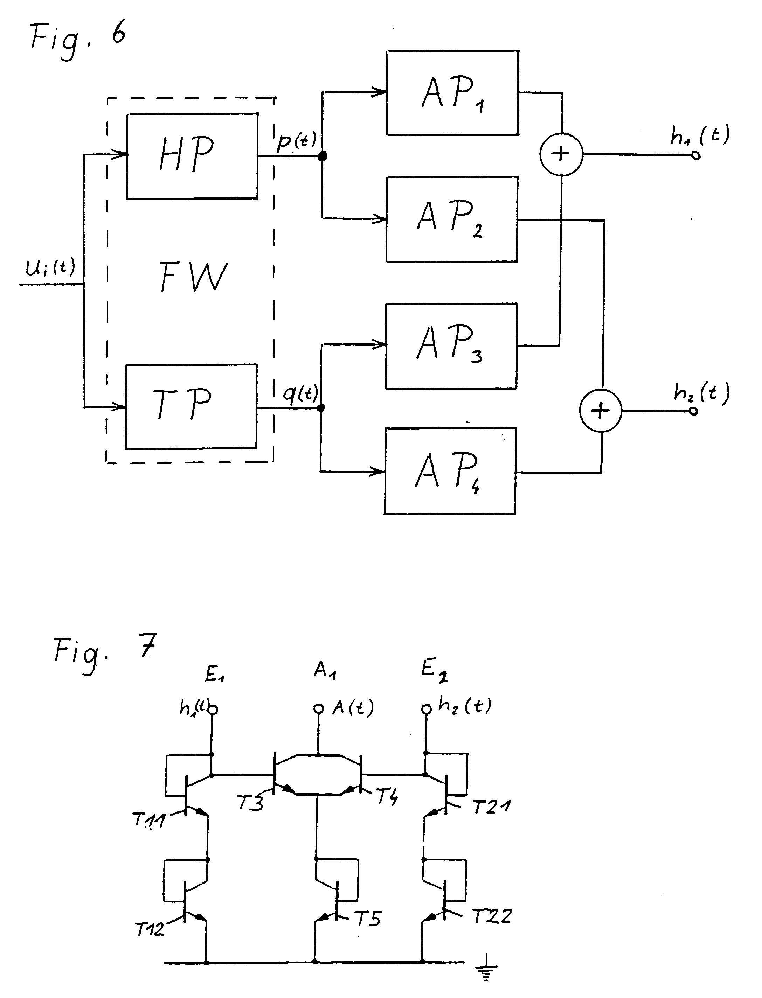

In der Fig. 5 ist der mögliche Aufbau der Hilbert-Schaltung HS nach Fig. 4 im einzelnen dargestellt. Bei dieser ist der Eingang IN in bekannter Weise mit einem Verstärker 1 und einer Brückenschaltung 2 verbunden, deren beide Zweige mit dem Ausgang des Verstärkers 1 verbunden sind.

Die beiden Zweige der Brückenschaltung 2 sind durch je eine Reihenschaltung eines Widerstandes 3, 4 mit einem Kondensator 5, 6 und je eine mit diesem verbundene Parallelschaltung eines Widerstandes 7, 8 mit einem Kondensator 9, 10 gebildet, wobei die Bauteile in den beiden Zweigen unterschiedlich dimensioniert sind. Der Abgriff der beiden Ausgangssignale $h_1(t)$, bzw. $h_2(t)$ erfolgt an den Verbindungspunkten der Reihen-R/C Glieder mit den Parallel-R/C Gliedern. Die Widerstände und Kapazitäten sind passend zu wählen.

Falls mit der Schaltung nach Fig. 4 und 5 der Frequenzbereich, in dem die Hilbert-Transformation ausreichend genau durchgeführt wird, zu schmal ist, kann eine Frequenzweiche FW vorgesehen sein, die z. B. aus einem Hochpaß HP und einem Tiefpaß TP besteht, wie dies in der Fig. 6 dargestellt ist. Die Teilsignale p(t) und q(t) werden mittels mehrerer Paare von Allpässen $AP_1$, $AP_2$; $AP_3$, $AP_4$ getrennt transformiert und im Anschluß addiert, um die Hilbert-Signale $h_1(t)$ und $h_2(t)$ zu gewinnen.

In der Fig. 7 ist eine Verknüpfungsschaltung dargestellt, die aus den an den Eingängen $E_1$ und $E_2$ anliegenden Signalen $h_1(t)$ und $h_2(t)$ am Ausgang $A_1$ das Signal:

$$A(t) = \sqrt{h_1^2(t) + h_2^2(t)}$$

erzeugt.

Eine solche Schaltung ist an sich bekannt, z.B. aus FERRANTI: Analog IC-Design, 1980. Sie weist zwei Reihenschaltungen von Transistoren T11, T12, T21 und T22 auf, deren Basen mit ihren Kollektoren verbunden sind, wobei an diesen Reihenschaltungen die zu verknüpfenden Eingangssignale $h_1(t)$ und $h_2(t)$ anliegen. Diese liegen weiters an den Basen zweier parallel geschalteter Transistoren T3, T4 an, zu denen ein weiterer Transistor T5 in Reihe geschaltet ist, dessen Basis mit dessen Kollektor verbunden ist. Dabei fließt über die parallel geschalteten Transistoren T3, T4 ein Strom A(t), der

$$A(t) = \sqrt{h_1^2(t) + h_2^2(t)}$$

entspricht, wobei $h_1(t)$ und $h_2(t)$ die Eingangsströme sind.

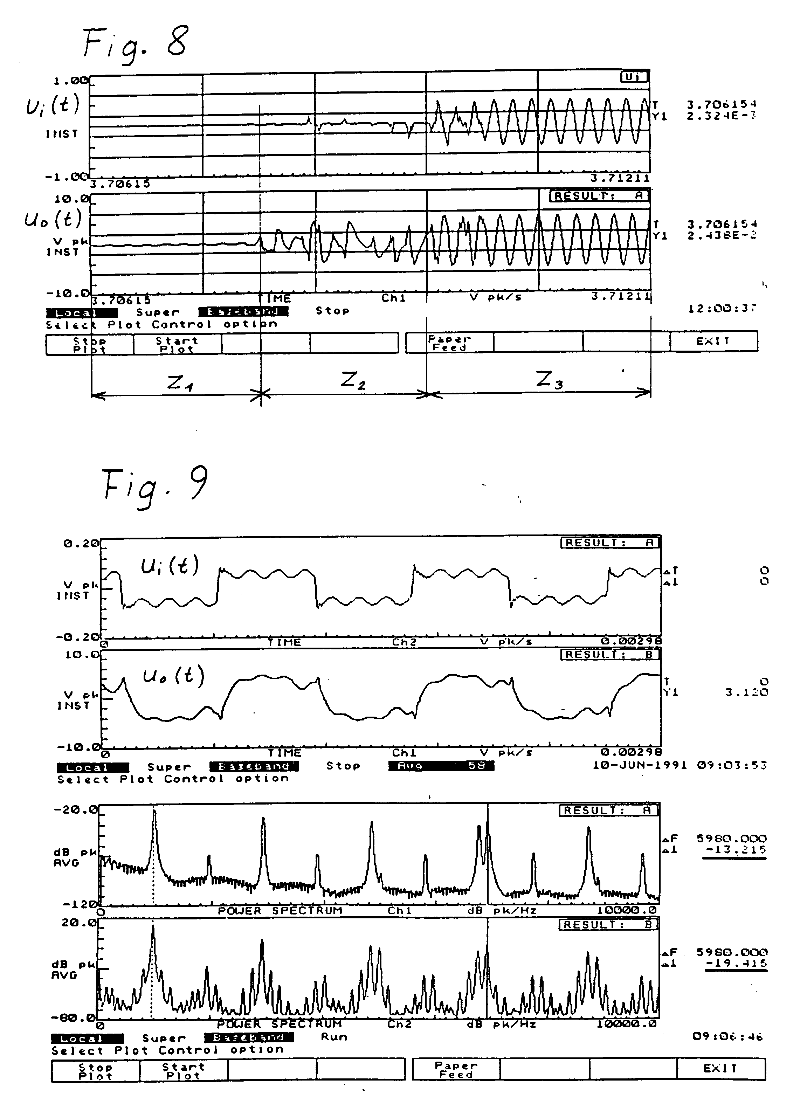

Die erfindungsgemäße Schaltung, insbesonders in der Variante von Fig. 1 wirkt als Kontrastverstärker, der ein Rauschen unterdrückt. Aus der Fig. 8 ist zu entnehmen, daß die Ansprechzeit tatsächlich praktisch Null ist. Die obere Kurve zeigt das Eingangssignal $u_i(t)$, die untere das Ausgangssignal $u_o(t)$. Das Eingangssignal $u_i(t)$ ist während der ersten Zeitperiode $Z_1$ Null, während der zweiten Zeitperiode $Z_2$ klein und während der dritten Zeitperiode $Z_3$ groß. Die Amplitude des Ausgangssignales ist weitgehend unabhängig von der Amplitude des Eingangssignals.

Die Fig. 9 zeigt die Wirkung als Kontrastverstärker. Die obere Kurve zeigt das Eingangssignal $u_i(t)$, die untere das Ausgangssignal $u_o(t)$. Das Eingangssignal $u_i(t)$ setzt sich aus einem Rechtecksignal mit überlagerter Sinusschwingung zusammen. Im darunter dargestellten Ausgangssignal $u_o(t)$ ist das Rechtecksignal noch gut zu erkennen, wogegen das Sinussignal weitgehend geglättet ist.

Die unteren beiden Kurven von Fig. 9 zeigen die spektrale Verteilung von Eingangssignal $u_i(t)$ und Ausgangssignal $u_o(t)$. Wesentlich ist, daß beim Eingangssignal $u_i(t)$ der Spitzenwert etwa 13 dB über dem Minimalwert liegt, wogegen beim Ausgangssignal $u_o(t)$ der Spitzenwert etwa 19 dB über dem Minimalwert liegt.

**Patentansprüche**

1. Verfahren zur Bearbeitung von Signalen, insbesonders von Audio-Signalen für Hörgeräte, dadurch gekennzeichnet, daß zunächst ein momentanes Amplitudensignal A(t) hergestellt wird, das der Amplitude des Eingangssignales $u_i(t)$ entspricht und daß dieses momentane Amplitudensignal A(t) zur Bearbeitung des Eingangssignales $u_i(t)$ herangezogen wird.

2. Verfahren nach Anspruch 1, dadurch gekennzeichnet, daß das Eingangssignal $u_i(t)$ durch das gegebenenfalls um eine Konstante K vermehrte momentane Amplitudensignal A(t) dividiert wird.

3. Verfahren nach einem der Ansprüche 1 oder 2, dadurch gekennzeichnet, daß das momentane Amplitudensignal A(t) zur Steuerung der Verstärkung des Eingangssignales $u_i(t)$ herangezogen wird.

4. Verfahren nach einem der Ansprüche 1 bis 3, dadurch gekennzeichnet, daß das momentane Amplitudensignal A(t) folgendermaßen erzeugt wird:
   - Erzeugung eines analytischen Signales, bestehend aus zwei Hilbert-Signalen $h_1(t)$, $h_2(t)$, dessen Energiespektrum dem des Eingangssignales $u_i(t)$ entspricht;
   - Bildung der Quadratwurzel aus der Summe der Quadrate der beiden Hilbert-Signale $h_1(t)$ und $h_2(t)$.

5. Vorrichtung zur Bearbeitung von Signalen, insbesonders von Audio-Signalen für Hörgeräte, dadurch gekennzeichnet, daß eine Amplitudensignalschaltung (ASS) vorgesehen ist, mit der ein momentanes Amplitudensignal A(t) herstellbar ist und daß weiters ein Verknüpfungsglied (VG) vorgesehen ist, in dem dieses Amplitudensignal A(t) mit dem Eingangssignales $u_i(t)$ verknüpft wird.

6. Vorrichtung nach Anspruch 5, dadurch gekennzeichnet, daß das Verknüpfungsglied (VG) eine Divisionsschaltung (DS) aufweist, in der das Eingangssignal $u_i(t)$ durch das momentane Amplitudensignal A(t) dividiert werden kann.

7. Vorrichtung nach Anspruch 6, dadurch gekennzeichnet, daß ein Addierer (ADD) sowie eine einstellbare Signalquelle (Q) vorgesehen sind, wobei an den Eingängen des Addierers (ADD) der Ausgang der Amplitudensignalschaltung (ASS) sowie der einstellbaren Signalquelle (Q) angeschlossen sind.

8. Vorrichtung nach Anspruch 5, dadurch gekennzeichnet, daß an den Ausgang der Amplitudensignalschaltung (ASS) ein nichtlineares Übertragungsglied (NLP) angeschlossen ist, das einen spannungsgesteuerten Verstärker (VCA) für das Eingangssignal $u_i(t)$ ansteuert.

9. Vorrichtung nach Anspruch 8, dadurch gekennzeichnet, daß zum nichtlinearen Übertragungsglied (NLP) ein Zeitglied ($\tau$) in Serie geschaltet ist.

10. Vorrichtung nach einem der Ansprüche 5 bis 9, dadurch gekennzeichnet, daß die Amplitudensignalschaltung (ASS) folgende Bestandteile aufweist:
- eine Hilbert-Schaltung (HS) mit zwei Ausgängen, an denen zwei aus einem Eingangssignal $u_i(t)$ gewonnene Hilbert-Signale $h_1(t)$ und $h_2(t)$ anliegen, die die beiden Komponenten eines analytischen Signales darstellen;
- eine Verknüpfungsschaltung (VS), die mit ihren beiden Eingängen an die Ausgänge der Hilbert-Schaltung (HS) angeschlossen ist und die bei an den Eingängen anliegenden Signalen $h_1(t)$ und $h_2(t)$ ein Ausgangssignal A(t) nach folgendem Algorithmus erzeugt:

$$A(t) = \sqrt{h_1{}^2(t) + h_2{}^2(t)}.$$

11. Vorrichtung nach Anspruch 10, dadurch gekennzeichnet, daß die Hilbert-Schaltung (HS) aus mindestens zwei Allpässen ($AP_1$, $AP_2$) besteht.

12. Vorrichtung nach Anspruch 11, dadurch gekennzeichnet, daß eine Frequenzweiche (FW) vorgesehen ist, deren Ausgänge mit mehreren Paaren von Allpässen ($AP_1$, $AP_2$; $AP_3$, $AP_4$) verbunden sind.

Fig. 1

Fig. 2

Fig. 3

Fig. 4

Fig. 5

Fig. 6

Fig. 7

*Fig. 8*

*Fig. 9*

## EUROPÄISCHER RECHERCHENBERICHT

**Europäisches Patentamt**

Nummer der Anmeldung

EP 92 89 0238

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-4 495 643 (ORBAN) <br> * Zusammenfassung; Abbildung 1 * <br> * Spalte 2, Zeile 65 - Zeile 68 * <br> * Spalte 4, Zeile 27 - Zeile 59 * | 1 | H03F1/32 <br> H04R25/00 |
| A | US-A-4 398 158 (RODGERS) <br> * Zusammenfassung; Abbildung 1 * | 1 | |
| A | US-A-4 182 993 (TYLER) <br> * Zusammenfassung; Abbildung 2 * <br> * Spalte 4, Zeile 43 - Zeile 54 * <br> * Spalte 5, Zeile 33 - Zeile 53 * | 1,8 | |
| A | WO-A-8 402 793 (HENRICKSON ET AL.) <br> * Zusammenfassung; Abbildung 1 * <br> * Seite 3, Zeile 20 - Seite 4, Zeile 12 * | 1,6 | |
| A | DE-A-3 512 405 (BOSE CORP.) <br> * Seite 18, Zeile 34 - Seite 19, Zeile 17; Abbildung 7 * | 6,7 | |
| A | PATENT ABSTRACTS OF JAPAN <br> vol. 013, no. 390 (E-813)29. August 1989 <br> & JP-A-11 36 407 ( HITACHI LTD. ) 29. Mai 1989 <br> * Zusammenfassung * | 11 | **RECHERCHIERTE SACHGEBIETE (Int. Cl.5)** <br><br> H03F <br> H04R <br> H03G <br> H03D |
| A | PATENT ABSTRACTS OF JAPAN <br> vol. 006, no. 205 (E-136)16. Oktober 1982 <br> & JP-A-57 113 646 ( HISAO OIKAWA ) 15. Juli 1982 <br> * Zusammenfassung * | 12 | G10L <br> H04J |

Der vorliegende Recherchenbericht wurde für alle Patentansprüche erstellt

| Recherchenort | Abschlußdatum der Recherche | Prüfer |
|---|---|---|
| BERLIN | 22 FEBRUAR 1993 | DANIELIDIS S. |